(19) Europäisches Patentamt / European Patent Office / Office européen des brevets

(11) **EP 2 186 318 B1**

(12) **FASCICULE DE BREVET EUROPEEN**

(45) Date de publication et mention
de la délivrance du brevet:
**16.11.2011 Bulletin 2011/46**

(21) Numéro de dépôt: **08803287.5**

(22) Date de dépôt: **27.08.2008**

(51) Int Cl.:
***H04N 5/355*** *(2011.01)*    ***H04N 5/3745*** *(2011.01)*

(86) Numéro de dépôt international:
**PCT/EP2008/061261**

(87) Numéro de publication internationale:
**WO 2009/027449 (05.03.2009 Gazette 2009/10)**

(54) **PIXEL ACTIF CMOS A TRES GRANDE DYNAMIQUE DE FONCTIONNEMENT**

AKTIVES CMOS-PIXEL MIT SEHR HOHER FUNKTIONSDYNAMIK

CMOS ACTIVE PIXEL WITH VERY HIGH FUNCTIONAL DYNAMICS

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **28.08.2007 FR 0757225**

(43) Date de publication de la demande:
**19.05.2010 Bulletin 2010/20**

(73) Titulaire: **New Imaging Technologies
91370 Verrières-le-Buisson (FR)**

(72) Inventeur: **NI, Yang
F-91120 Palaiseau (FR)**

(74) Mandataire: **Le Forestier, Eric et al
Cabinet Regimbeau
20, rue de Chazelles
75847 Paris Cedex 17 (FR)**

(56) Documents cités:
**US-B1- 6 242 728    US-B1- 6 784 934**

**Description**

L'invention concerne la technologie d'intégration CMOS (Complementary Metal Oxyde Semiconductor, selon la terminologie anglo-saxonne), qui met en oeuvre une famille de composants électroniques à faible consommation électrique.

L'invention concerne en particulier les pixels CMOS.

La technologie d'intégration CMOS permet de réaliser des puces pour caméras monolithiques de bonne résolution et de qualité d'image raisonnable. Ces caméras monolithiques sont principalement destinées aux appareils mobiles tels que téléphones mobiles, assistants numériques personnels (PDA, Personal Digital Assistant, selon la terminologie anglo-saxonne) ou ordinateurs portables. Les images prises par ces caméras servent essentiellement à la visualisation sur écran ou sur Internet.

L'aspect très économique de ce type de caméra suscite un intérêt toujours croissant pour les applications ayant trait à des modes de visualisation artificielle, comme l'airbag intelligent de voiture, le contrôle latéral et longitudinal d'une voiture sur l'autoroute, la vidéosurveillance de zones sensibles etc... Il est aisément concevable que pour ce type d'applications la prise de vue se fasse en général dans des conditions d'éclairage peu idéales, dépassant largement la plage dynamique conférée à ce genre de capteurs CMOS à bas coût, les empêchant ainsi de fournir une réponse acceptable en terme de dynamique de fonctionnement.

L'une des difficultés majeures lors de l'utilisation d'une telle caméra réside dans l'étendue de la variation du niveau d'éclairage pour une même scène. Cette variation peut facilement dépasser 120 dB entre des zones fortement éclairées et des zones mal éclairées. Une caméra CMOS/CCD classique ayant une réponse linéaire peut difficilement s'en accommoder, et produit généralement des images totalement ou partiellement saturées, entraînant la perte d'informations pertinentes et conduisant à un système de vision instable.

Une seconde difficulté réside dans l'ampleur et la vitesse de variation de la lumière dans une scène dynamique. Le mécanisme de contrôle automatique de l'exposition réalisé par une caméra classique ne peut y répondre convenablement et produit par conséquent des saturations totales ou partielles.

Ces phénomènes de saturations sont extrêmement préjudiciables à un bon fonctionnement d'un système de vision.

De nombreuses méthodes proposent de résoudre ce problème en créant des structures de pixel actives possédant une dynamique de fonctionnement élargie grâce à une réponse photoélectrique non linéaire présentant une baisse de sensibilité en cas d'éclairage important.

Le document EP1354360 décrit une structure de pixel active à réponse logarithmique basée sur l'exploitation d'une photodiode en régime photovoltaïque.

Dans le domaine de la technologie CMOS standard, une photodiode est formée généralement d'une jonction PN avec une diffusion N dans un substrat du type P. En fonctionnement photovoltaïque, cette photodiode génère une tension négative en circuit ouvert dont la valeur absolue est proportionnelle au logarithme du niveau d'éclairage de la photodiode. Un commutateur permet de créer un court-circuit dans cette photodiode afin de simuler la condition d'obscurité en présence d'un éclairage normal. Une lecture différentielle entre la tension générée par la photodiode en circuit ouvert et celle en court-circuit permet de supprimer les bruits de décalage additifs dans la chaîne de lecture et d'obtenir ainsi une image propre.

Des circuits prototypes implantant la structure du pixel décrit dans le document EP1354360 ont donné une très grande dynamique de fonctionnement et une qualité d'image satisfaisante. Néanmoins, cette structure de pixel souffre encore d'un certain nombre de lacunes.

En effet, elle manque tout d'abord de compacité physique, ce manque étant le résultat de la présence simultanée obligatoire des transistors NMOS et PMOS au sein d'un même pixel, qui nécessite un caisson d'isolation faisant perdre une grande partie de la surface utile. Or, cette perte de surface augmente la taille du pixel, réduit la taille de la photodiode et par conséquent réduit également la performance photoélectrique.

Ensuite, au sein de cette structure, la photodiode évolue uniquement en mode photovoltaïque. Or, en raison d'une forte compression logarithmique, ce mode de fonctionnement génère un signal de sortie de très faible amplitude, limitant ainsi le rapport signal sur bruit pouvant être obtenu en cas d'une illumination diurne.

Enfin, le transistor de commutation de court circuit présente une certaine conductivité résiduelle pendant sa désactivation. Ce phénomène devient critique dans une réalisation en technologie CMOS submicronique.

En outre, si le document EP1354360 décrit une structure de pixel active exploitant la zone logarithmique, il n'en va pas de même pour la majorité des pixels actifs existants, qui exploitent au contraire la zone linéaire de l'évolution de la tension sur une photodiode après son initialisation. La raison en est que le fonctionnement d'une photodiode dans la partie mixte ou logarithmique est réputé poser des problèmes photoélectriques au sein d'une matrice, par conséquent il est en général évité qu'une photodiode entre dans ces zones.

Or, une exploitation complète de la plage d'évolution génère un signal de forte amplitude grâce à la zone linéaire, et une dynamique de fonctionnement étendue grâce aux zones mixte et logarithmique. En effet, dans la zone linéaire, le bruit relatif du signal image est fortement réduit de sorte que l'image obtenue est de bonne qualité ; cependant, la plage dynamique reste faible. Les zones mixte et logarithmique au contraire compressent fortement l'amplitude du signal image de manière à éliminer presque totalement la saturation dudit signal, mais la faible amplitude et la polarité négative du signal image rendent sa lecture difficile. Il serait donc intéressant de combiner les trois zones de manière à obtenir à la fois une bonne qualité d'image et une plage dynamique étendue.

Les documents US 6 242 728 et US 6 784 934 décrivent une structure de pixel à grande dynamique de fonctionnement selon le preambule de la revendication 1.

Un but de l'Invention est de fournir au moins une structure de pixel à très grande dynamique de fonctionnement, qui non seulement possède une grande compacité physique mais permette également d'améliorer significativement le rapport signal sur bruit.

A cet effet, il est prévu, selon l'invention, une structure d'un pixel actif de type CMOS comprenant au moins une photodiode, **caractérisée en ce qu'**elle comporte des moyens pour lire une tension de polarité quelconque dans la phase d'évolution de la photodiode lors d'une exposition. Cela confère à ladite structure de pixel une grande dynamique de fonctionnement permettant une amélioration notoire du rapport signal sur bruit.

La structure du pixel et son fonctionnement sont définis dans les revendication 1 et 15.

Avantageusement, mais facultativement, la structure comporte au moins l'une des caractéristiques suivantes :

- les moyens pour lire une tension de polarité quelconque comprennent un transistor de lecture,
- la structure comporte un amplificateur tampon comportant le transistor de lecture et un transistor de charge,
- le transistor de charge est situé à l'intérieur de la structure du pixel,
- le transistor de charge est situé à l'extérieur de la structure du pixel,
- une tension de seuil du transistor de lecture est inférieure à une tension la plus négative traversant la photodiode,
- la structure comporte un moyen permettant d'envoyer un signal de sortie de l'amplificateur tampon sur un bus de communication,
- le moyen d'envoi du signal de sortie de l'amplificateur tampon sur un bus de communication est un quatrième transistor branché sur un signal de sélection,
- la structure comporte en outre un condensateur de couplage capacitif monté en série entre la photodiode et l'amplificateur tampon,
- la structure comporte des moyens d'installation d'une tension sur le condensateur de couplage au sein du pixel,
- les moyens d'installation sont une résistance montée entre l'amplificateur tampon et une source de tension positive,
- la résistance est constituée d'un transistor NMOS connecté en diode,

- le drain et la grille dudit transistor NMOS sont connectés à deux sources d'alimentation différentes,
- les moyens d'installation sont une injection d'une charge positive sous rayonnement ultraviolet dans l'armature du condensateur de couplage connectée à l'amplificateur tampon,
- les moyens d'installation sont une injection d'une charge positive par effet tunnel dans l'armature du condensateur de couplage connectée à l'amplificateur tampon,
- la photodiode est utilisée comme l'une des armatures du condensateur de couplage,
- la structure comporte un transistor d'initialisation apte à être désactivé par une application d'une tension négative, et
- les transistors susmentionnés sont de même type NMOS ou PMOS, et le transistor de lecture est de type NMOS à appauvrissement.

Il est également prévu, selon l'invention, un procédé de fonctionnement d'un pixel selon l'invention, caractérisé par le fait qu'il comprend les étapes consistant à : initialiser une photodiode, avant une prise de vue, à une tension V initiale, à l'aide d'un signal RAZ (remise à zéro) activant le transistor d'initialisation ; désactiver le transistor d'initialisation et laisser la photodiode évoluer sous une illumination pendant l'exposition ; effectuer une première lecture à la fin de l'exposition à l'aide d'un signal de sélection SEL ; et effectuer une deuxième lecture pendant ou subitement après la réactivation du transistor d'initialisation.

Avantageusement, mais facultativement, le procédé de fonctionnement d'un pixel exploite les zones suivantes de l'évolution de la tension sur la photodiode après son initialisation :

- la zone linéaire,
- la zone logarithmique,
- la zone mixte.

D'autres caractéristiques, buts et avantages de l'invention ressortiront encore de la description qui suit, laquelle est purement illustrative et non limitative, et doit être lue en regard des dessins annexés, sur lesquels :

- la figure 1a est une vue d'un photorécepteur avec une photodiode en mode photovoltaïque selon l'art antérieur,
- la figure 1b est une vue d'une structure d'un pixel muni d'un photorécepteur selon l'art antérieur,
- la figure 2 est une courbe représentant l'évolution de la tension sur une photodiode après son initialisation,
- les figures 3a et 3b sont deux vues d'une structure de pixel selon un premier mode de réalisation ne faisant pas partie de l'invention,
- les figures 4a et 4b sont deux chronogrammes montrant le fonctionnement d'un pixel selon respectivement le premier et un deuxième modes de réalisation de l'invention,

- la figure 5 est une vue d'une structure de pixel selon un deuxième mode de réalisation de l'invention,
- les figures 6a, 6b, 6c, 6d et 6e sont cinq vues d'une structure de pixel selon cinq variantes du deuxième mode de réalisation de l'invention,
- les figures 7a et 7b sont deux vues d'une structure de pixel selon deux autres variantes du deuxième mode de réalisation de l'invention,
- la figure 8a est une vue d'une structure de pixel selon une autre variante du deuxième mode de réalisation de l'invention,
- la figure 8b est une vue partielle d'une structure de pixel selon une autre variante du deuxième mode de réalisation de l'invention,
- la figure 9 est une vue d'un transistor type, et
- la figure 10 est une vue d'une configuration matricielle d'une structure de pixel.

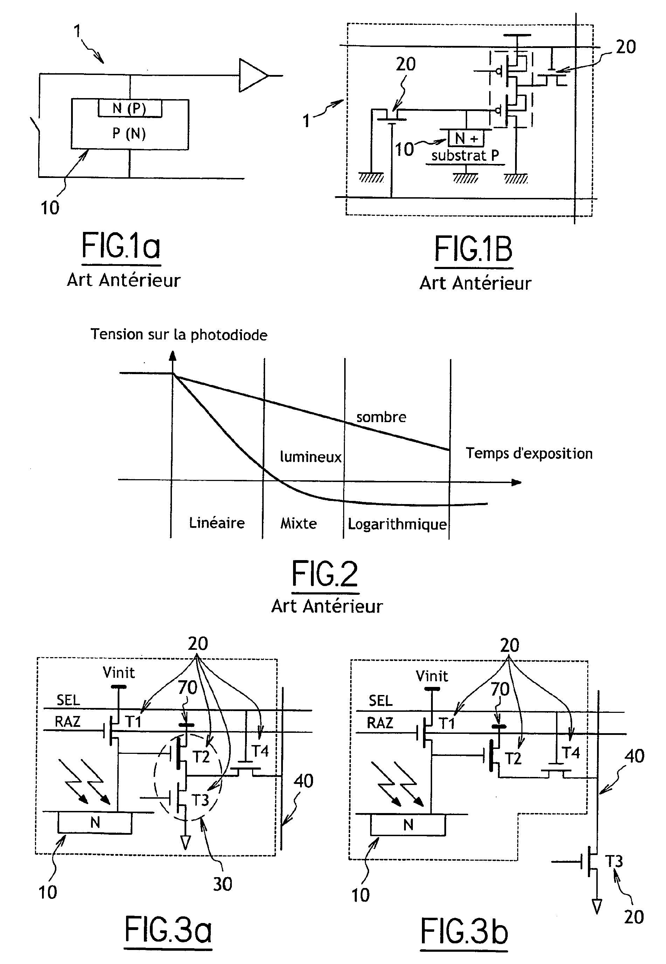

En référence aux figures 3a à 4a, nous allons décrire maintenant un premier mode de réalisation ne faisant pas partie de l'invention.

Selon ce premier mode de réalisation une structure de pixel 1 comporte :

- une photodiode 10 ayant une capacité de jonction $C_{PD}$, réalisée par une diffusion de type N dans un substrat du type P,
- des transistors 20, dont au moins un transistor d'initialisation T1 de type NMOS, pour N Metal Oxyde Semiconductor selon la terminologie anglosaxonne,
- des moyens pour lire une tension de polarité quelconque dans la photodiode 10 lorsque cette dernière est illuminée.

Un transistor à appauvrissement de type N possède une tension de seuil $T_S$ négative - la tension de seuil $T_S$ étant la tension au niveau d'un des pôles du transistor appelé « grille » G, les deux autres pôles étant la « source » S et le « drain » D - qui lui permet de se maintenir « passant » quand une tension supérieure à $T_S$, et en particulier une tension négative appartenant à l'intervalle [$T_S$ ; 0], est appliquée entre la grille G et la source S. Quand la photodiode 10 évolue dans une zone logarithmique, une tension négative susceptible d'être présente est relativement faible : elle ne dépasse pas 0,7 V en valeur absolue. Donc une tension de seuil $T_S$ de l'ordre de -1 V permet de lire la tension de la photodiode 10 sur toute la plage de son évolution et de la translater en tension purement positive à l'aide d'un tel transistor à appauvrissement, exploitable par des circuits de lecture classique.

La photodiode 10 est utilisée en polarisation inverse. Avant une prise de vue, un générateur externe ou interne au pixel produit une tension initiale $V_{init}$ inverse alimentant le transistor d'initialisation T1, lequel installe

cette tension initiale $V_{init}$ inverse dans la photodiode 10. Cette opération est appelée « initialisation ou remise à zéro (RAZ) de la photodiode ».

En variante de réalisation, la tension initiale est programmable. Ainsi, elle permet de déterminer la plage d'utilisation de la photodiode 10 qui débute soit dans la zone linéaire, soit dans la zone mixte soit dans la zone logarithmique (cf figure 2), en fonction de la luminosité à laquelle elle est soumise et des conditions de son utilisation qui suit cette initialisation.

Ensuite, pendant une période dite d'exposition $T_{\exp}$, le transistor T1 est désactivé, de manière à ce qu'un courant photoélectrique $I\lambda$ induit au sein de la photodiode 10, alors illuminée, décharge progressivement la tension dans la photodiode 10. Une variation entre la tension initiale dans la photodiode 10 et une tension obtenue à la fin de l'exposition constitue le signal de sortie du pixel 1. La courbe de tension de la photodiode 10 est visible sur la figure 2.

La plage d'évolution d'une photodiode se divise en deux zones principales, définies comme suit.

Si l'intensité de lumière est relativement faible, à la fin de la période d'exposition, la photodiode reste en polarisation inverse. C'est à dire que la tension sur la photodiode reste positive où $C_{PD}$ est la capacité de jonction de la photodiode et $T_{\exp}$ est le temps d'exposition. Donc il est dit dans ce cas que la photodiode travaille dans la zone linéaire.

Si la lumière au contraire est très intense, la photodiode sera déchargée complètement et la tension sur la photodiode devient alors négative :

$$V_{PD} = -\frac{kT}{q}\ln(\frac{I_\lambda}{I_S} + 1) < 0$$ où $k$ est la constante de Boltzmann, $q$ est la charge élémentaire, T est la température absolue de fonctionnement de la photodiode et $I_S$ représente un courant inverse appelé également courant de saturation de la jonction de la photodiode, observé lorsqu'une diode est polarisée en inverse en absence totale de lumière. La tension sur la photodiode devient proportionnelle au logarithme de l'intensité lumineuse. Il est dit dans ce cas que la photodiode travaille en zone logarithmique.

Après l'exposition, la tension $V_{PD}$ de la photodiode 10 est donc devenue soit

$$V_{PD} = V_{init} - \frac{I_\lambda * T_{\exp}}{C_{PD}} > 0$$ si la photodiode 10 reste dans la zone linéaire, soit

$$V_{PD} = -\frac{kT}{q}\ln(\frac{I_\lambda}{I_S} + 1) < 0$$ si la photodiode 10 entre dans la zone logarithmique.

Un suiveur MOS 30 - appelé aussi amplificateur tampon - est raccordé entre le transistor d'initialisation T1 et la photodiode 10. Il comporte des moyens de lecture d'une tension de polarité quelconque dans la photodiode 10. Ces moyens de lecture comprennent un transistor de lecture T2 NMOS à appauvrissement. Le suiveur 30 comporte également un transistor T3 ayant une fonction de charge inclus dans le pixel 1. En variante, le transistor T3 est disposé à l'extérieur du pixel 1. La configuration plaçant la charge T3 dans le pixel 1 est cependant plus stable que celle la plaçant à l'extérieur du pixel 1.

Le transistor de lecture T2 NMOS à appauvrissement est ici utilisé, sur toute la plage où il est passant, pour translater le niveau électrique de la tension lue sur la photodiode 10 afin d'obtenir une tension formant un signal de sortie, exploitable par le circuit utilisant ce signal de sortie.

Pour transmettre le signal de sortie du suiveur 30 sur un bus de communication 40, le suiveur 30 est connecté sélectivement sur le bus 40 à l'aide d'un quatrième transistor T4, appelé transistor de sélection. Ce dernier est activable par un signal de sélection SEL, arrivant sur la grille du transistor T4. Ce mécanisme de sélection permet un accès à un pixel déterminé dans une matrice de pixel. A la fin de l'exposition, une première lecture L1 est faite au moyen de ce signal SEL. Cette lecture donne la tension finale dans la photodiode 10 plus une composante de décalage $V_{offset}$ de la translation, apportée par le suiveur de tension 30.

A la fin de la période d'exposition, le transistor d'initialisation T1 est réactivé. Une deuxième lecture L2 est alors faite pendant ou immédiatement après la fin de la réactivation du transistor d'initialisation T1. Cette lecture L2 donne la tension initiale dans la photodiode 10 ajoutée à la composante de décalage $V_{offset}$ du suiveur de tension 30.

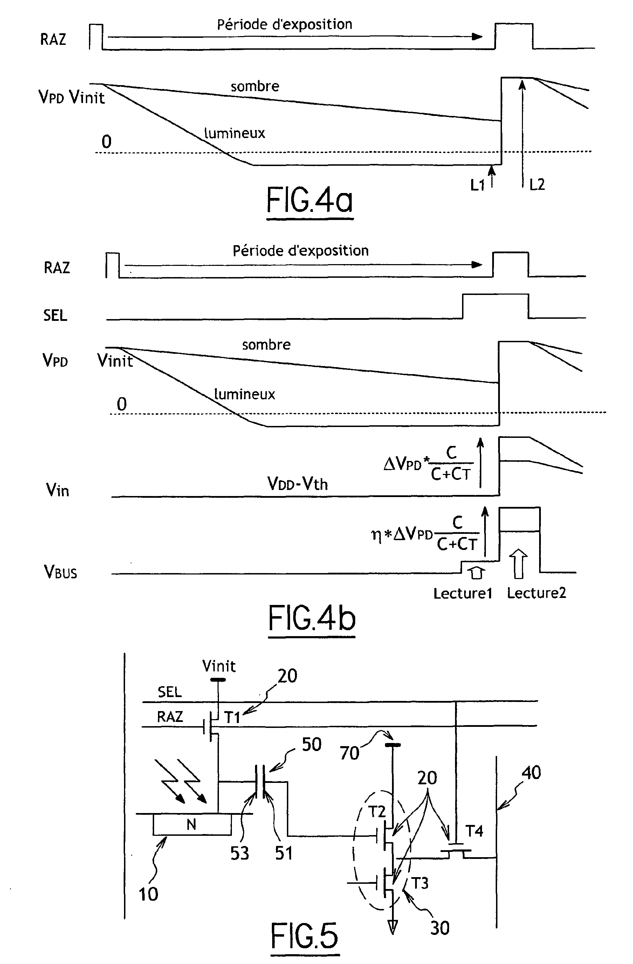

Une soustraction entre les valeurs de ces deux lectures donne un signal d'image exempt de décalage du suiveur de tension 30 au sein du pixel 1. La figure 4a donne un chronogramme du fonctionnement du pixel 1.

Dans le cas de cette réalisation, la structure de pixel 1 n'utilise qu'un seul type de transistor 20. Cela supprime le besoin de caisson d'isolation, nécessaire lors de la présence simultanée de transistors NMOS et PMOS au sein d'un même pixel 1, et procure un gain de place important au sein du pixel 1. Cette économie de surface utile permet de ne pas réduire la photodiode 10 et donc de gagner en performance photoélectrique.

Un autre but de l'invention est de fournir au moins une structure de pixel pouvant exploiter toute la plage d'évolution d'une photodiode, ce qui signifie pouvoir exploiter, en plus de la zone linéaire, les parties mixte et logarithmique pour lesquelles la tension sur la photodiode devient négative.

Or, un pixel compact utilisant un seul type de transistors ne peut normalement lire qu'une tension positive de la photodiode illuminée.

Un autre but de l'invention est donc de fournir au moins une structure de pixel permettant, en utilisant un seul type de transistor, d'exploiter toutes les zones d'évolution de la photodiode.

En référence aux figures 4b à 8b, nous allons décrire maintenant un deuxième mode de réalisation de l'invention.

Selon ce deuxième mode particulier de réalisation de l'invention, une structure de pixel 1 comporte :

- une photodiode 10 ayant une capacité de jonction $C_{PD}$, réalisée par une diffusion N dans un substrat du type P,
- des transistors 20, dont au moins un transistor d'initialisation T1 de type NMOS,
- des moyens pour lire une tension de polarité quelconque dans la photodiode 10 illuminée,
- un condensateur de couplage capacitif 50.

Cette seconde structure de pixel 1 propose l'exploitation de la plage complète de l'évolution d'une photodiode 10 sans utiliser de transistor NMOS à appauvrissement pour T2.

Le fonctionnement du pixel 1 est identique à celui de la première structure : la photodiode 10 est initialisée à une tension de référence par l'activation du transistor T1, puis lorsque le transistor T1 est désactivé, la photodiode 10 se décharge pendant la période d'exposition, à la fin de laquelle deux lectures de la tension de la photodiode 10 sont effectuées, l'une avant la réactivation du transistor T1 et l'autre après ou pendant la réactivation du transistor T1. Une soustraction entre les valeurs de ces deux lectures donne un signal d'image propre puisque exempt de décalage du suiveur de tension 30 au sein du pixel 1.

La différence par rapport à la première structure de pixel 1 réside dans le fait que la cathode de la photodiode 10 est couplée, non pas avec un transistor de lecture T2 NMOS à appauvrissement, mais avec un transistor de lecture T2 de type NMOS normal à tension de seuil $T_S$ positive, au moyen d'un condensateur de couplage capacitif 50. La tension à l'entrée du transistor de lecture T2 est ainsi le résultat de la somme entre la tension de la photodiode 10 et la tension du condensateur 50 monté en série. Il est possible, en fonction de la quantité et de la polarité des charges au sein du condensateur 50, de translater la tension de la photodiode 10 dans une plage manipulable par le transistor de lecture T2. L'installation d'une quantité de charges adéquate au sein du condensateur 50 permet au transistor de lecture T2 de lire la tension de la photodiode 10 sur toute la plage de son évolution, de sorte que la tension ainsi obtenue soit toujours supérieure à la tension de seuil $T_S$ du transistor de lecture T2 NMOS.

Différentes méthodes sont proposées pour installer une tension adéquate sur le condensateur de couplage 50 au sein d'un pixel 1.

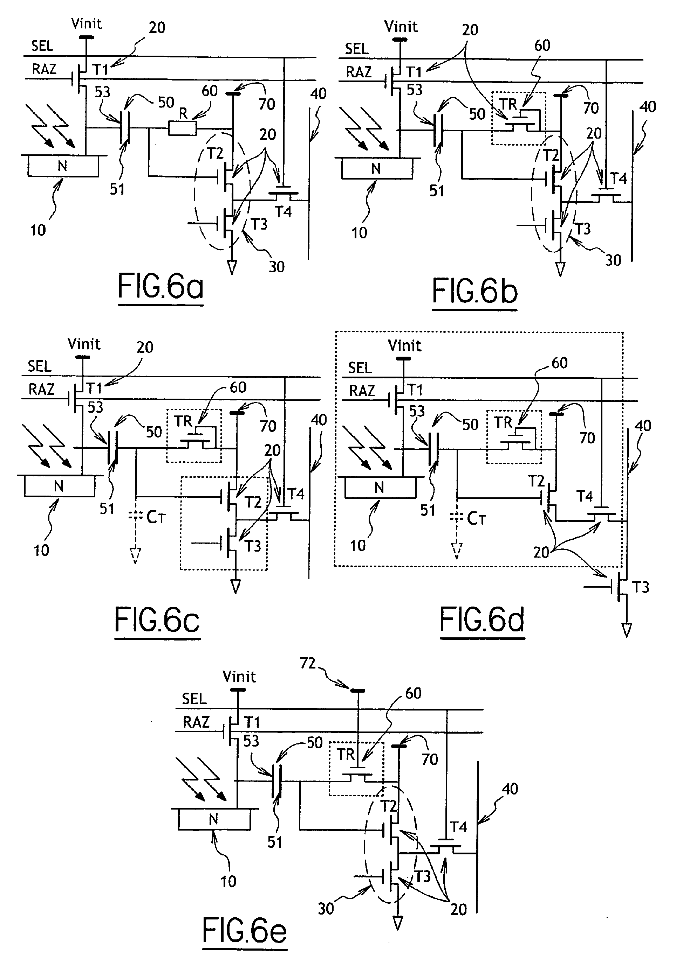

Une première méthode illustrée sur les figures 6a à 6e consiste à connecter l'entrée (grille) du transistor de lecture T2 à une tension positive d'une valeur supérieure à la tension de seuil $T_S$ du transistor de lecture T2 à travers une résistance 60 constituée d'un transistor TR NMOS et connectée à une source de tension positive 70. La résistance 60 est de valeur R déterminée telle qu'une constante de temps RC, où C est la capacité du condensateur de couplage 50, soit, par exemple, dix fois supérieure à l'intervalle de temps existant entre les deux lectures L1, L2 à la fin de l'exposition. De cette façon, il n'existe pratiquement pas de perte de charge sur le condensateur 50 entre les deux lectures et le signal d'image est alors retransmis fidèlement à l'entrée du transistor de lecture T2.

En variante, comme illustré sur la figure 6e, le transistor TR est alimenté au niveau de sa grille par une source de tension 72 alors que son drain est connecté à la source de tension 70. Les deux sources de tension 70 et 72 peuvent être de même tension ou de tensions différentes.

Dans le cadre de cette première méthode, la première lecture prélève la tension à la sortie du suiveur 30, cette tension étant sensiblement égale à $V_{DD}$-$V_{th}$ où $V_{DD}$ est la tension de l'alimentation 70 et $V_{th}$ est la tension de seuil du transistor TR. La sortie du suiveur 30 se traduit par : $(V_{DD}$-$V_{th})$-$Voffset$. La valeur de cette lecture est par la suite stockée dans une mémoire soit analogique soit digitale, pouvant se trouver soit sur une puce comportant des pixels soit à l'extérieur de celle-ci.

La deuxième lecture est faite de la même façon que pour le premier mode de réalisation de l'invention : par l'activation du signal RAZ. Lorsque celui-ci est activé pour la deuxième fois, la tension sur la photodiode 10 est à nouveau initialisée à $V_{init}$. Cela provoque une variation de tension sur la photodiode 10 qui est égale soit

à $\Delta V_{PD} = \dfrac{I_\lambda * T_{exp}}{C_{PD}}$ si la photodiode 10 reste dans la zone linéaire, soit à $\Delta V_{PD} = V_{init} + \dfrac{kT}{q}\ln(\dfrac{I_\lambda}{I_s}+1)$

si la photodiode 10 entre dans la zone logarithmique. Cette variation positive de la tension de la photodiode 10 crée également une variation positive à l'entrée du suiveur 30 à travers le condensateur 50, laquelle variation positive bloque momentanément le transistor 60. La valeur de la variation à l'entrée du suiveur de tension 30

est égale à $\Delta V_{PD} * \dfrac{C}{C+C_T}$ où $C_T$ représente la capacité parasite équivalente à l'entrée du suiveur 30 et C la capacité du condensateur 50.

La variation de tension à la sortie du suiveur 30 après la réactivation du transistor d'initialisation T1 peut être écrite de la façon suivante :

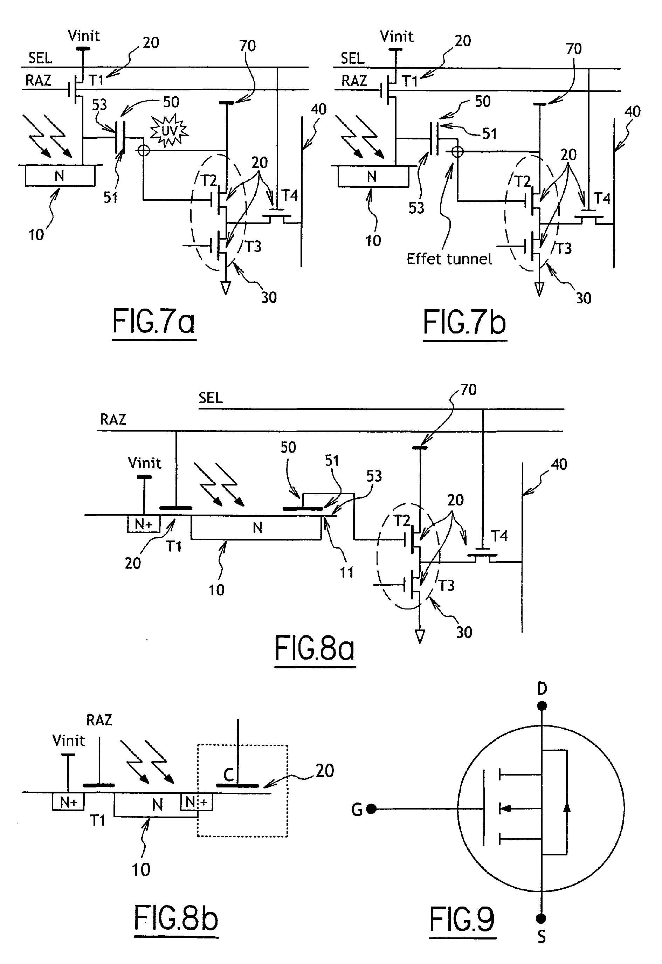

$(V_{DD}-V_{th})-V_{offset}+\eta*\Delta V_{PD}\dfrac{C}{C+C_T}$ représente le gain du suiveur 30. Une lecture de cette valeur est effectuée, puis cette valeur est soustraite à la valeur de la première lecture : $(V_{DD}$-$V_{th})$-$V_{offset}$. De la sorte, un signal d'image est obtenu : $\eta*\Delta V_{PD}\dfrac{C}{C+C_T}$ , qui est linéaire avec le signal d'image sur la photodiode 10 ; en d'autres termes la variation entre les deux signaux est conservée.
En variante, la résistance 60 est réalisée en couche(s) mince(s) après la formation des transistors 20 intégrés.
Une deuxième méthode illustrée sur les figures 7a et 7b consiste à utiliser une conductivité ponctuelle au sein d'un isolant électrique. Cette conductivité ponctuelle peut émaner de différents phénomènes physiques :

1. un rayonnement ionisant,
2. un effet tunnel d'électrons froids,
3. l'effet d'électrons chauds.

Il est possible dans ce cas d'ajouter un dispositif d'injection de charge au condensateur 50 qui installe de façon contrôlée (implicite ou explicite) une quantité adéquate de charge au sein de ce condensateur 50. Cette injection de charge peut se faire de deux façons :

1. tension de décalage installée sur le condensateur de couplage 50 au moyen d'une injection d'une charge positive sous rayonnement ultraviolet dans son armature 51 connectée au suiveur de tension 30 (figure 7a),
2. surtension appliquée au condensateur de couplage 50 au moyen d'une injection d'une charge positive par effet tunnel dans son armature 51 connectée au suiveur de tension 30 de type NMOS normal (figure 7b).

Comme montré sur la figure 8a, il est possible de réduire le courant d'obscurité de la photodiode 10 en utilisant sa cathode 11 comme l'une des armatures 51, 53 du condensateur de couplage 50. Pour cela, la diffusion N de la source S du transistor T1 est fusionnée avec la diffusion N de la photodiode 10. Cet arrangement physique supprime le besoin de contact ohmique sur la photodiode 10, de manière à éviter à la photodiode 10 des dommages physiques potentiels liés à la réalisation des contacts, et à réduire le courant inverse $I_S$ la traversant.
En variante, le condensateur 50 peut être réalisé avec un transistor 20 dont le drain D ou la source S ou les deux sont confondus avec la diffusion N de la photodiode 10 (voir figure 8b).
Dans le cas des deux modes particuliers de réalisation de l'invention, toute la plage de l'évolution de la photodiode 10 est exploitée.
Quand la photodiode 10 évolue en zone logarithmique, la tension négative de la photodiode 10 peut provoquer une conduction involontaire du transistor d'initialisation T1, entraînant des bruits fixes ou variables sur l'image acquise et diminuant ainsi fortement la qualité de l'image. Pour pallier ce défaut, une tension négative est appliquée à la grille G du transistor T1 pendant la période d'exposition. Cette tension négative supprime la conduction parasite du transistor T1 de sorte de le désactiver. Elle peut être fournie par une source d'alimentation extérieure ou par un générateur interne au capteur CMOS comprenant le pixel 1.

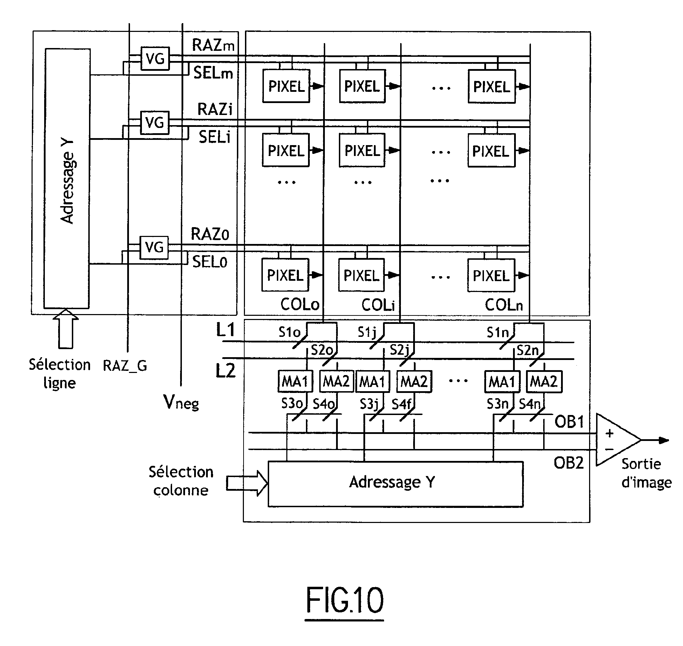

Une incorporation du pixel de l'invention dans une configuration matricielle à deux dimensions de (m+1) lignes et de (n+1) colonnes est illustrée dans la Fig. 10. Cette figure illustre de façon non exclusive un mode de réalisation particulier conforme à la description de la structure de pixel 1 de l'invention, dont la personne de l'art saura aisément déduire d'autres conceptions.

Le fonctionnement de cette configuration est le suivant : une ligne de pixels est sélectionnée par une application d'une adresse Yi à un circuit d'adressage Y. Une sortie de pixels de la ligne Yi est connectée sur un bus de lecture colonne COL. La sortie de cette ligne est échantillonnée et stockée dans une mémoire analogique MA1 par l'activation du signal L1. Un signal RAZ_G est ensuite activé, entraînant également l'activation de la remise à zéro des pixels de la ligne Yi sélectionnée. La sortie de cette ligne est échantillonnée dans une deuxième mémoire analogique MA2 par le signal L2. Une fois cette phase d'accès de ligne terminée, une adresse X est appliquée à un circuit d'adressage X. Les contenus des mémoires analogiques MA1 et MA2 sont aiguillés vers un amplificateur différentiel via des bus OB1 et OB2. Cet amplificateur différentiel réalise une différence qui permet une suppression des erreurs de décalage dans la lecture.

Bien entendu la présente invention n'est pas limitée aux modes de réalisation particuliers qui viennent d'être décrits, mais s'étend à toutes variantes conformes à son esprit.

En variante, de façon non limitative et non exclusive, les transistors T1, T2, T3, T4 et TR sont de type PMOS.

**Revendications**

1. Structure d'un pixel actif de type CMOS (1) comprenant :

   au moins une photodiode (10),
   - Un transistor d'initialisation (T1) pour initialiser la photodiode à une tension initiale,
   - des moyens pour lire une tension de polarité quelconque dans la phase d'évolution de la photodiode (10) lors d'une exposition,

   et en ce que les moyens pour lire une tension de polarité
   comportent un amplificateur tampon (30) comportant un transistor de lecture (T2) et un transistor (T3) de charge **caractérisé en ce que** la structure du pixel actif comporte en outre un condensateur de couplage capacitif (50), monté en série entre la photodiode (10) et une entrée du transistor de lecture (T2), et des moyens d'installation d'une tension sur le condensateur de couplage (50) au sein du pixel (1) pour translater la tension de la photodiode et permettre au transistor de lecture (T2) de lire la tension de la photodiode sur toute la plage de son évolution.

2. Structure d'un pixel actif de type CMOS (1) selon la revendication 1, **caractérisée en ce que** le transistor de charge (T3) est situé à l'intérieur de la structure du pixel (1).

3. Structure d'un pixel actif de type CMOS (1) selon la revendication 1, **caractérisée en ce que** le transistor de charge (T3) est situé à l'extérieur de la structure du pixel (1).

4. Structure d'un pixel actif de type CMOS (1) selon la revendication 1, **caractérisée en ce qu'**une tension de seuil du transistor de lecture (T2) est inférieure à une tension la plus négative apte à traverser la photodiode (10).

5. Structure d'un pixel actif de type CMOS (1) selon la revendication 1, **caractérisée en ce qu'**elle comporte un moyen permettant d'envoyer un signal de sortie de l'amplificateur tampon (30) sur un bus de communication (40).

6. Structure d'un pixel actif de type CMOS (1) selon la revendication 5, **caractérisée en ce que** le moyen d'envoi du signal de sortie de l'amplificateur tampon (30) sur un bus de communication (40) est un transistor (T4) branché sur un signal de sélection (SEL).

7. Structure d'un pixel actif de type CMOS (1) selon l'une des revendications 1 à 6, **caractérisée en ce que** les moyens d'installation sont une résistance (60) montée entre l'amplificateur tampon (30) et une source de tension positive (70).

8. Structure d'un pixel actif de type CMOS (1) selon la revendication 7, **caractérisée en ce que** la résistance (60) est constituée d'un transistor (TR) NMOS connecté en diode.

9. Structure d'un pixel actif de type CMOS (1) selon la revendication 7, **caractérisée en ce que** le drain et la grille du transistor (TR) sont connectés à deux sources d'alimentation (70, 72) différentes.

10. Structure d'un pixel actif de type CMOS (1) selon l'une quelconque des revendications 1 à 6, **caractérisée en ce que** les moyens d'installation sont une injection d'une charge positive sous rayonnement ultraviolet dans l'armature (51) du condensateur de couplage (50) connectée à l'amplificateur tampon (30).

**11.** Structure d'un pixel actif de type CMOS (1) selon l'une quelconque des revendications 1 à 6, **caractérisée en ce que** les moyens d'installation sont une injection d'une charge positive par effet tunnel dans l'armature (51) du condensateur de couplage (50) connectée à l'amplificateur tampon (30).

**12.** Structure d'un pixel actif de type CMOS (1) selon la revendication 11, **caractérisée en ce que** la photodiode (10) est utilisée comme l'une des armatures (51, 53) du condensateur de couplage (50).

**13.** Structure d'un pixel actif de type CMOS (1) selon l'une quelconque des revendications 1 à 12, **caractérisée en ce qu'**elle comporte un transistor d'initialisation (T1) apte à être désactivé par une application d'une tension négative.

**14.** Structure d'un pixel actif de type CMOS (1) selon l'une quelconque des revendications 1 à 13, **caractérisée en ce que** les transistors (T1, T2, T3, T4, TR) sont de même type NMOS ou PMOS.

**15.** Procédé de fonctionnement d'un pixel (1) selon l'une quelconque des revendications 1 à 14, **caractérisé par le fait qu'**il comprend les étapes consistant à :

1) Initialiser une photodiode (10), avant une prise de vue, à une tension V initiale, à l'aide d'un signal RAZ activant le transistor d'initialisation (T1);
2) Installer une quantité de charge déterminée au sein du condensateur de couplage capacitif (50) ;
3) Désactiver le transistor d'initialisation (T1) et laisser la photodiode (10) évoluer sous une illumination pendant l'exposition ;
4) Effectuer une première lecture à la fin de l'exposition à l'aide d'un signal de sélection SEL, et
5) Effectuer une deuxième lecture pendant ou subitement après la réactivation du transistor d'initialisation (T1).

**Claims**

**1.** A structure of an active pixel of the CMOS type (1) comprising:

- at least one photodiode (10),
- an initialization transistor (T1) to initialize the photodiode at an initial voltage.
- means for reading a voltage with any polarity in the variation phase of the photodiode (10) during exposure, and in that the means for reading a polarity voltage include a buffer amplifier (30) including a read-out transistor (T2) and a charging transistor (T3) **characterized in that** the structure of the active pixel also includes a capacitive coupling capacitor (50), assembled in series between the photodiode (10) and an input of the read-out transistor (T2), and means of installation of a voltage on the coupling capacitor (50) within the pixel (1) to translate the voltage of the photodiode and enable the read-out transistor (T2) to read the voltage of the photodiode over its full range of variation.

**2.** The structure of an active pixel of the CMOS type (1) according to claim 1, **characterized in that** the charging transistor (T3) is located inside the structure of the pixel (1).

**3.** The structure of an active pixel of the CMOS type (1) according to claim 1, **characterized in that** the charging transistor (T3) is located outside the structure of the pixel (1).

**4.** The structure of an active pixel of the CMOS type (1) according to claim 1, **characterized in that** a threshold voltage of the read-out transistor (T2) is less than a voltage, the most negative voltage capable of passing through the photodiode (10).

**5.** The structure of an active pixel of the CMOS type (1) according to claim 1, **characterized in that** it includes a means by which an output signal from the buffer amplifier (30) may be sent over a communications bus (40).

**6.** The structure of an active pixel of the CMOS type (1) according to claim 5, **characterized in that** the means for sending the output signal of the buffer amplifier (30) over a communications bus (40) is a transistor (T4) connected to a selection signal (SEL).

**7.** The structure of an active pixel of the CMOS type (1) according to any of claims 1 to 6, **characterized in that** the means of installation are a resistor (60) assembled between the buffer amplifier (30) and a positive voltage source (70).

**8.** The structure of an active pixel of the CMOS type (1) according to claim 7, **characterized in that** the resistor (60) consists of an NMOS transistor (TR) connected as a diode.

**9.** The structure of an active pixel of the CMOS type (1) according to claim 7, **characterized in that** the drain and the gate of the transistor (TR) are connected to two different power supply sources (70, 72).

**10.** The structure of an active pixel of the CMOS type (1) according to any of claims 1 to 6, **characterized in that** the means of installation are an injection of a positive charge under ultraviolet radiation into the plate (51) of the coupling capacitor (50) connected to the buffer amplifier (30).

**11.** The structure of an active pixel of the CMOS type (1) according to any of claims 1 to 6, **characterized in that** the means of installation are an injection of a positive charge by the tunnel effect into the plate (51) of the coupling capacitor (50) connected to the buffer amplifier (30).

**12.** The structure of an active pixel of the CMOS type (1) according to claim 11, **characterized in that** the photodiode (10) is used like one of the plates (51, 53) of the coupling capacitor (50).

**13.** The structure of an active pixel of the CMOS type (1) according to any of claims 1 to 12, **characterized in that** it includes a reset transistor (T1) capable of being disabled by application of a negative voltage.

**14.** The structure of an active pixel of the CMOS type (1) according to any of claims 1 to 13, **characterized in that** the transistors (T1, T2, T3, T4, TR) are of the same type, either NMOS or PMOS.

**15.** A method for operating a pixel (1) according to any of claims 1 to 14, **characterized by** the fact that it includes the steps of:

1) Initializing a photodiode (10), before taking images, to an initial voltage V, with a CLEAR signal enabling the reset transistor (T1);
2) Installing a determined charge quantity within the capacitive coupling capacitor (50);
3) Disabling the reset transistor (T1) and letting the photodiode (10) vary under illumination during the exposure;
4) Performing a first read-out at the end of the exposure with an SEL selection signal, and
5) Performing a second read-out during or immediately after re-enablement of the reset transistor (T1).

**Patentansprüche**

**1.** Struktur eines aktiven CMOS-Pixels (1) mit:

- mindestens einer Fotodiode (10),
- einem Initialisierungstransistor (T1) zum Initialisieren der Fotodiode mit einer Anfangsspannung, und
- Einrichtungen zum Lesen einer beliebigen Polarisationsspannung in der Entwicklungsphase der Fotodiode (10) während einer Aufnahme, wobei die Einrichtungen zum Lesen einer Polarisationsspannung einen Pufferverstärker (30) aufweisen, der einen Lesetransistor (T2) und einen Ladetransistor (T3) aufweist,

**dadurch gekennzeichnet, dass** die Struktur des aktiven Pixels außerdem aufweist: einen kapazitiven Kopplungskondensator (50), der in Serienschaltung zwischen der Fotodiode (10) und einem Eingang des Lesetransistors (T2) angeordnet ist, und Versorgungsmittel zum Anlegen einer Spannung an dem Kopplungskondensator (50) in dem Pixel (1), um die Spannung der Fotodiode zu verschieben und dem Lesetransistor (T2) ein Lesen der Spannung der Fotodiode über den gesamten Entwicklungsbereich zu erlauben.

**2.** Struktur eines aktiven CMOS-Pixels (1) nach Anspruch 1, **dadurch gekennzeichnet, dass** der Ladetransistor (T3) innerhalb der Struktur des Pixels (1) angeordnet ist.

**3.** Struktur eines aktiven CMOS-Pixels (1) nach Anspruch 1, **dadurch gekennzeichnet, dass** der Ladetransistor (T3) außerhalb der Struktur des Pixels (1) angeordnet ist.

**4.** Struktur eines aktiven CMOS-Pixels (1) nach Anspruch 1, **dadurch gekennzeichnet, dass** eine Schwellenspannung des Lesetransistors (T2) kleiner ist als die negativste Spannung, die über der Fotodiode (10) anliegen kann.

**5.** Struktur eines aktiven CMOS-Pixels (1) nach Anspruch 1, **dadurch gekennzeichnet, dass** sie eine Einrichtung aufweist, die erlaubt, ein Ausgangssignal des Pufferverstärkers (30) über einen Kommunikationsbus (40) zu übertragen.

**6.** Struktur eines aktiven CMOS-Pixels (1) nach Anspruch 5, **dadurch gekennzeichnet, dass** die Einrichtung zum Übertragen eines Ausgangssignals des Pufferverstärkers (30) über einen Kommunikationsbus (40) ein Transistor (T4) ist, der an ein Auswahlsignal (SEL) angeschlossen ist.

**7.** Struktur eines aktiven CMOS-Pixels (1) nach einem der Ansprüche 1 bis 6, **dadurch gekennzeichnet, dass** die Versorgungsmittel ein Widerstand (60) sind, der zwischen dem Pufferverstärker (30) und einer positiven Spannungsquelle (70) angeordnet ist.

**8.** Struktur eines aktiven CMOS-Pixels (1) nach Anspruch 7, **dadurch gekennzeichnet, dass** der Widerstand (60) aus einem als Diode geschalteten NMOS-Transistor (TR) besteht.

9. Struktur eines aktiven CMOS-Pixels (1) nach Anspruch 7, **dadurch gekennzeichnet, dass** die Drain-Elektrode und die Gate-Elektrode des Transistors (TR) mit zwei unterschiedlichen Spannungsquellen (70,72) verbunden sind.

10. Struktur eines aktiven CMOS-Pixels (1) nach einem der Ansprüche 1 bis 6, **dadurch gekennzeichnet, dass** die Versorgungsmittel eine Injektion einer positiven Ladung in den an dem Pufferverstärker (30) angeschlossenen Elektrode (51) des Kopplungskondensators (50) unter Ultraviolettstrahlung sind.

11. Struktur eines aktiven CMOS-Pixels (1) nach einem der Ansprüche 1 bis 6, **dadurch gekennzeichnet, dass** die Versorgungsmittel eine Injektion einer positiven Ladung in den an dem Pufferverstärker (30) angeschlossenen Elektrode (51) des Kopplungskondensators (50) mittels Tunneleffekt sind.

12. Struktur eines aktiven CMOS-Pixels (1) nach Anspruch 11, **dadurch gekennzeichnet, dass** die Fotodiode (10) als einer der Elektroden (51,53) des Kopplungskondensators (50) verwendet wird.

13. Struktur eines aktiven CMOS-Pixels (1) nach einem der Ansprüche 1 bis 12, **dadurch gekennzeichnet, dass** sie einen Initialisierungstransistor (T1) aufweist, der durch Anlegen einer negativen Spannung deaktiviert werden kann.

14. Struktur eines aktiven CMOS-Pixels (1) nach einem der Ansprüche 1 bis 13, **dadurch gekennzeichnet, dass** die Transistoren (T1,T2,T3,T4,TR) vom gleichen NMOS- oder PMOS-Typ sind.

15. Arbeitsverfahren eines Pixels (1) nach einem der Ansprüche 1 bis 14, **gekennzeichnet durch** die folgenden Schritte:

   1) Initialisieren einer Fotodiode (10) mit einer Anfangsspannung V mit Hilfe eines Nullstellungssignals, das den Initialisierungstransistor (T1) aktiviert, vor Aufnehmen eines Bilds;
   2) Versorgen des kapazitiven Kopplungskondensators (50) mit einer bestimmten Ladungsmenge;
   3) Deaktivieren des Initialisierungstransistors (T1) und Zulassen der Entwicklung der Fotodiode unter Belichtung während der Aufnahme;
   4) Durchführen eines ersten Lesens am Ende der Aufnahme mit Hilfe eines Auswahlsignals SEL und
   5) Durchführen eines zweiten Lesens während oder unmittelbar nach der Reaktivierung des Initialisierungstransistors (T1).

## FIG.1a
### Art Antérieur

## FIG.1B
### Art Antérieur

Tension sur la photodiode

sombre

lumineux

Temps d'exposition

Linéaire    Mixte    Logarithmique

## FIG.2
### Art Antérieur

Vinit

SEL
RAZ    T1    70
            T2

T4

T3

N

10    30    40

## FIG.3a

Vinit

SEL
RAZ    T1    70

T2    T4

N

10    40

T3

20

## FIG.3b

RAZ

Période d'exposition

VPD Vinit

sombre

0

lumineux

L1 L2

## FIG.4a

RAZ

Période d'exposition

SEL

VPD Vinit

sombre

0

lumineux

Vin

$\Delta V_{PD} * \dfrac{C}{C+C_T}$

$V_{DD} - V_{th}$

VBUS

$\eta * \Delta V_{PD} \dfrac{C}{C+C_T}$

Lecture1 Lecture2

## FIG.4b

Vinit 20

SEL

RAZ T1

50 70

20

N 40

T2 T4

53 51

T3

10 30

## FIG.5

FIG.6a

FIG.6b

FIG.6c

FIG.6d

FIG.6e

FIG.7a

FIG.7b

FIG.8a

FIG.8b

FIG.9

## FIG.10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1354360 A
- US 6242728 B
- US 6784934 B